# EUROPEAN PATENT APPLICATION

(11) **EP 1 271 631 A1**
(43) Date of publication of application: **02.01.2003**
(21) Application number: 01870148.2
(22) Date of filing: 29.06.2001
(51) Int. Cl.: H01L 21/3105

(54) **A method for producing semiconductor devices using chemical mechanical polishing**

(71) Applicant: INTERUNIVERSITAIR MICRO-ELEKTRONICA CENTRUM VZW, 3001 Heverlee (BE)
(72) Inventor: Rooyackers, Rita, 3010 Leuven (BE)
(74) Representative: Van Malderen, Joelle

(57) **Abstract**

The present invention is related to a method for producing semiconductor devices from a semiconductor substrate (1), comprising the following steps :
- providing a substrate (1) having on its surface a number of elevated areas (2) separated by areas (5) which are at a lower level, each elevated area (2) having as its top surface a first layer (4) of a material which is resistant to Chemical Mechanical Polishing,
- Depositing a layer (6) of a dielectric on top of the whole of said substrate (1), at least filling the gaps between said elevated areas,
- Depositing a second layer (7) of a material which is resistant to CMP on top of the whole of said substrate (1),
- Removing parts (8) of said second CMP resistant layer (7) and of said layer (6) of a dielectric, said parts being situated above elevated areas (2) having a dimension larger than a predefined minimum,
- Performing a CMP step, said CMP being stopped at the location of said first and second CMP resistant layers (4,7).

## Description

### Field of the invention

The present invention is related to methods for producing semiconductor devices, comprising at least one production step wherein the technique of chemical mechanical polishing (CMP) is used, and to devices obtained by said methods.

### State of the art

In CMOS processing, electrical isolation of adjacent devices, for example transistors, is crucial. This isolation is commonly obtained in the first stages of the production process by forming a buried dielectric between devices, for which several techniques have been documented. Now that the scaling of semiconductor technologies is being taken into the deep submicron dimensions, many of the older methods (such as LOCOS based techniques) are no longer usable. Shallow trench isolation in combination with chemical mechanical polishing (STI-CMP) is now widely accepted as the isolation technique of choice for sub-0.25µm technologies.

Also in other parts of the CMOS production process, CMP forms a crucial step. This is the case for example in replacement gate techniques, wherein the polishing of the pre-metal dielectric (PMD) layer on top of the dummy gate stacks of the transistors on the device is of great importance.

In all steps requiring CMP, the topology of the surface that is to be polished must be taken into consideration. A very uneven surface will generally cause irregularities in the polishing process. These problems are explained in more detail in the following for the case of STI-CMP.

In STI, a nitride or other CMP resistant layer is deposited onto a semiconductor (in many cases a silicon) wafer, after which shallow trenches are etched into the wafer, leaving islands of nitride, which are later to become the locations of active areas (transistors, etc.). The trenches are then filled with oxide, for example by a chemical vapour deposition (CVD) technique, to form the dielectric areas, also called 'field regions' in between the active areas. After that, the planarisation of the wafer needs to be performed to perfection by a CMP step, in order to acquire optimal gate patterning later on.

One of the main problems is the difficulty of implementing a CMP process with good overall uniformity, without excessive oxide loss in the field regions ('dishing') and without eroding the nitride layer that covers small and especially isolated active areas, which is due to a difference in polish rate between said field regions and said active areas. A known solution to this problem is the introduction of 'dummy' active areas, in order to obtain a more uniform density of nitride-covered areas over the wafer's surface, thus avoiding the dishing phenomenon.

However, in the case of mixed-signal technologies, the routing of metal connections which are traversing such dummy active areas causes increased capacitive coupling and noise.

The problems encountered when performing CMP are also related to the technique used for the filling of the trenches. As known in the art, the High Density Plasma-CVD (HDP-CVD) technique yields a 'non-conformal' filling layer, which means that after filling of the trenches, the active areas are covered by volumes of HDP oxide with slanted sides, the cross-section of these volumes perpendicular to the wafer being trapezium-shaped for large active areas and triangular-shaped for small active areas. This is true even for very dense regions, i.e. regions where many small active areas are placed very close together. A conformal layer on the other hand, such as obtained by Low Pressure CVD or conventional Plasma Enhanced CVD techniques, covers the whole of the substrate surface, including dense regions with an even layer of near constant thickness.

HDP-CVD is preferred in current STI processing, since it is the method with the best gap filling capability. The surface topology after trench filling by HDP-CVD is however very uneven, which causes difficulties when applying CMP : the small volumes of HDP-oxide with triangular cross section on top of small active areas tend to be polished too quickly in comparison with the larger volumes on top of large active areas. This brings about the risk of nitride erosion on top of small active areas and dishing of field regions if polishing times are too long. Reduction of polishing times may solve this problem, but will increase the danger of an insufficient oxide removal on large active areas.

Since the use of dummy structures brought about its own particular difficulties described already, several solutions to these problems have been proposed so far. One of these is described in document EP-A-825645, which is related to a method for filling STI trenches in a semiconductor substrate of an integrated circuit. Active areas and trenches are filled with a HDP oxide layer after which a biased inverse active area mask of all active areas is used in order to remove oxide on top of all active areas, prior to a polishing step. This increases the uniformity of the surface before polishing and allows to reduce polish time, but the dishing effect is merely diminished by this method, and not eliminated. As stated above, a biased inverse active area mask of all active areas is used, which means that even on top of small active areas, a very small amount of oxide is to be removed. It is very difficult to perform correct lithography on such small features, due to reflection effects. Therefore, a correct patterning of the HDP oxide according to this document is nearly impossible.

Another approach is described in 'A new dummy-free shallow trench isolation concept for mixed-signal applications', G. Badenes et al, Journal of The Electrochemical Society, 147 (10) 3827-3832 (2000). According to the method described in this document, a second nitride layer is deposited above the trench filling oxide layer, prior to CMP. This second nitride layer acts as a CMP resistant layer above the large field regions, that way reducing the dishing effect.

In this so-called 'dual-nitride technique', an additional patterning step is done after the deposition of the second nitride layer. The pattern obtained is such that a layer of nitride is left intact only on the large field regions. This effectively reduces the dishing effect, but the uneven topology prior to CMP remains a problem. Especially in the case of HDP-oxide as trench filling material, the nitride layers on small active areas are in danger of being attacked by the polishing before all the oxide on larger active areas is removed.

Document US-A-5362669 describes a method for forming a fully planarised trench isolated region in a semiconductor substrate for an integrated circuit. A CMP resistant layer is deposited on top of the dielectric layer which is filling the trenches. The CMP resistant layer in the centre of a wide trench forms an etch stop to prevent dishing. From the figures and the description of this document, it is evident that the trench filling material used is a conformal material. This document does therefore not provide a solution to the specific problems related to the use of HDP oxide as a trench filling material.

Document EP-A-926715 proposes silicon carbide as a better CMP resistant layer than silicon nitride. This means less carbide will be removed in a comparable polishing step.

### Aims of the invention

The present invention aims to propose a process wherein a combination of actions is taken in order to prevent dishing of large field regions and/or excessive polishing on the active areas, during a CMP step.

In addition, the invention aims to propose a new CMP resistant layer which allows a better selectivity of the polishing process.

Finally, the process of the invention aims to provide a solution to the specific problem of the HDP oxide deposition on dense structures and/or small isolated active areas.

### Summary of the invention

The present invention is related to a method for producing semiconductor devices from a semiconductor substrate, comprising the following steps :
- providing a substrate having on its surface a number of elevated areas separated by areas which are at a lower level, each elevated area having as its top surface a first layer of a material which is resistant to Chemical Mechanical Polishing,
- Depositing a layer of a dielectric on top of the whole of said substrate, at least filling up said lower level areas between said elevated areas,
- Depositing a second layer of a material which is resistant to CMP on top of the whole of said layer of a dielectric,
- Removing parts of said second CMP resistant layer and of said layer of a dielectric, said parts being situated above elevated areas having a dimension larger than a predefined minimum,
- Performing a CMP step, said CMP being stopped at the location of said first and second CMP resistant layers.

According to a preferred embodiment, at least one of said elevated areas has a rectangular top surface and said dimension is the width of said rectangular top surface. In one embodiment, said predefined minimum is 1.8µm.

Preferably, the surface, parallel to the substrate, of said parts that are removed, is not larger than the surface of said elevated areas above which said parts are situated.

According to the method of the invention, said first and/or said second CMP resistant layers may be silicon nitride layers. One or both of these layers may alternatively be silicon carbide layers.

According to a preferred embodiment, the forming of said first and/or second layer of CMP resistant material comprises the following steps :
- depositing a layer of SiₓO_{y}N_{z},
- performing a thermal anneal, so that after said anneal a CMP resistant layer is formed underneath said SiₓO_{y}N_{z} layer.

Said SiₓO_{y}N_{z} layer may deposited on top of a Silicon nitride layer, or on top of a silicon carbide layer, or directly on top of said layer of a dielectric material.

Preferably, said thermal anneal takes place at a temperature which is lying between 1050°C and 1100°C and during a period of time between 10 minutes and 40 minutes.

Preferably, said SiₓO_{y}N_{z} layer has a thickness, before the anneal step, of at least 60nm.

According to a preferred embodiment of the method of the invention, said dielectric layer is formed by a high density plasma technique.

According to a preferred embodiment of the method of the invention, said elevated areas and said areas at a lower level are created using the technique of Shallow Trench Isolation.

According to another embodiment of the method of the invention, said elevated areas consist of dummy gate stacks in a replacement gate technique.

The invention is equally related to a device obtained by the method according to the invention.

### Short description of the drawings

Fig. 1 represents a stage in the process according to the invention, prior to the deposition of the trench filling oxide.

Fig. 2 represents a stage in the process according to the invention after the deposition of a second CMP resistant layer.

Fig. 3 represents a stage in the process according to the invention after the 'clear-out' operation.

Fig. 4 represents a stage in the process according to the invention after the CMP-step.

Fig. 5 represents the wafer's surface after removal of both CMP resistant layers.

Fig. 6 illustrates the process according to the invention of obtaining a CMP resistant layer, using silicon-oxy-nitride.

### Detailed description of the invention

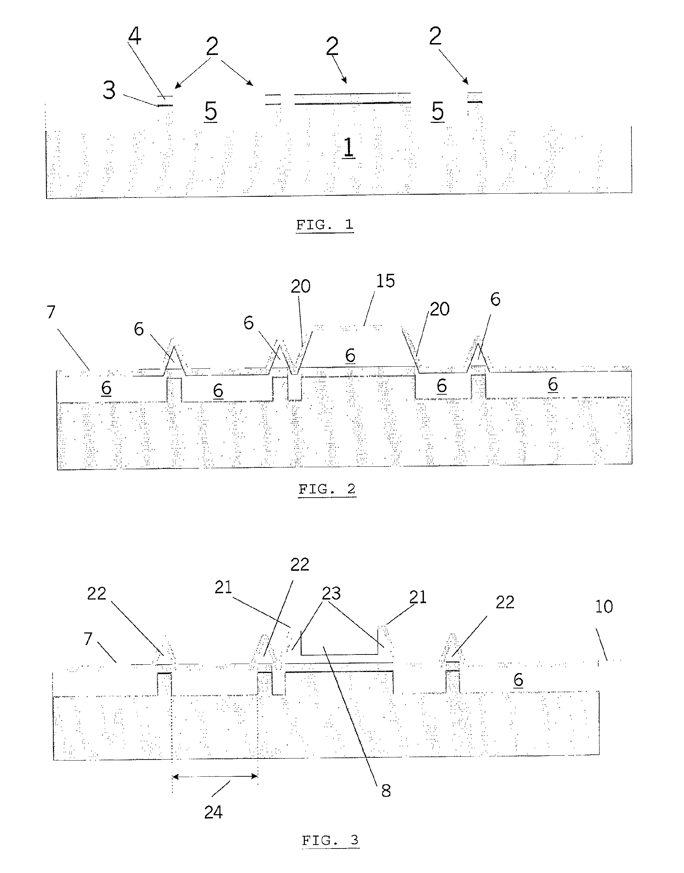

The invention is related to a method for producing semiconductor devices, starting from a semiconductor substrate, such as a silicon wafer. The characteristic part of the invention relates only to a number of steps in the production process, namely a number of steps up to and including the Chemical Mechanical Polishing step. The main characteristic steps of the method of the invention can be summarised as follows, with reference to the figures 1 to 5 :
- providing a substrate 1 having on one surface a number of elevated areas 2 separated by areas 5 which are at a lower level, each elevated area 2 having as its top surface a first layer 4 of a material which is resistant to Chemical Mechanical Polishing,
- Depositing a layer 6 of a dielectric on top of the whole of said substrate 1, at least filling up the lower level areas 5 between said elevated areas 2,
- Depositing a second layer 7 of a material which is resistant to CMP on top of the whole of said layer 6 of a dielectric,
- Removing parts 8 of said second CMP resistant layer 7 and of said layer 6 of a dielectric, said parts being situated above elevated areas 2 having a dimension larger than a predefined minimum,
- Performing a CMP step, said CMP being stopped by said first and second CMP resistant layers (4,7).

These steps can be found in different stages of a production process. In particular, the steps are applicable for performing STI-CMP in the beginning of the production process, leading to a very good polishing quality when HDP oxide is used as the trench filling oxide. In this case, the elevated areas 2 are the active areas, having preferably a nitride layer 4 on top, and the lower level areas 5 are the trenches formed by STI.

The step sequence described above might be used in other parts of the CMOS process, even though not all of the advantages relevant to the use of the steps in STI-CMP may be retained. In particular, in the polishing of pre-metal dielectric layers on top of dummy gate stacks, prior to a replacement gate technique, the method of the invention is applicable as such. In this case, the elevated areas 2 are the dummy gate stacks themselves. The lower level areas 5 then include the field regions consisting of field oxide and the parts of the active areas surrounding the gate stacks. It is to be noted that a level difference exists between the field oxide and the parts surrounding the gate stacks. The 'elevated areas' mentioned in the previous method steps refer only to the dummy gate stacks, in this particular case.

The following description is however restricted purely to STI-CMP, using HDP oxide as trench filling material. Figures 1 to 5 illustrate this process. A semiconductor substrate 1, preferably a silicon wafer is provided, upon which an silicon oxide layer 3 and a CMP resistant layer 4, preferably a silicon nitride layer (Si₃N₄), are consecutively deposited, after which trenches 5 are patterned (by a litho and etch step), leaving islands 2, or so-called 'active areas'. Figure 1 shows the condition after these first steps.

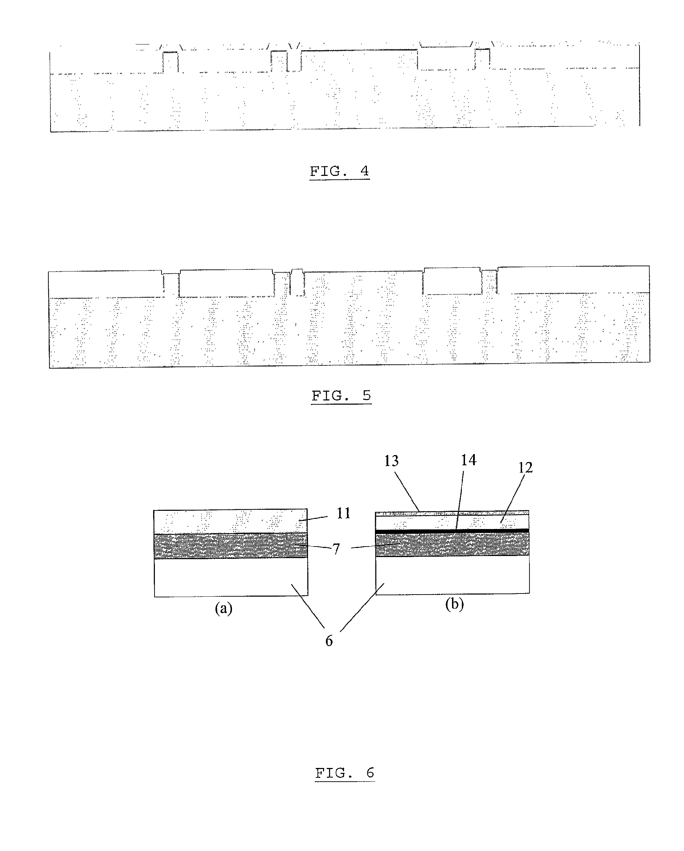

Following that, a layer 6 of HDP oxide is deposited, and on top of that, a second layer 7 of a CMP resistant material, see figure 2. After that, a 'clear-out' is done above the large active areas, i.e. a litho step and an etch step to remove part of the second CMP resistant layer 7 and part of the HDP oxide layer 6 in a well defined region 8 above each of said large active areas, see figure 3. The minimum size of what is called a 'large' active area is to be defined on the basis of the process parameters. Using HDP, an oxide body with a flat top 15 and slanted sides 20 is formed on active areas larger than a given size, while a triangular-shaped oxide body is formed on anything smaller than this predefined size. This predefined size depends largely on the HDP parameters, in particular on the deposition/etch ratio inherent to the HDP process. According to one embodiment, a flat top 15 is formed on areas with a rectangular top surface, and with a width larger than 1.2µm. In the same embodiment, the 'clear-out' is done above active areas with a width larger than 1.8µm.

The surface area of the region 8 is preferably smaller than the horizontal projection of the whole HDP oxide body on top of the active area concerned, including the slanted edges 20. In the case of a HDP oxide, the region 8, as seen in the cross section of figure 3, should preferably not go beyond the edges (points 21) of the flat top 15 of the oxide on top of the active area 2. This is to avoid damaging the edges of the actual active area 2 when the HDP oxide is, at least partially, removed during the 'clear-out' step, by an oxide-etching process. If this oxide-etching process is not selective to the CMP resistant layer 4, this layer 4 will be at least partially etched at the edges of the active area, which will result in a lower CMP stopping power at these edges. If too much oxide is removed at the edges, this also brings about the risk of damaging the active areas during the polishing step.

According to the preferred embodiment, I-line lithography is used for the patterning of regions 8. In this embodiment, the area 8 is patterned as being 0.6µm smaller than the active areas 2. This relatively simple lithography step allows the use of a mask derived from the active area mask and is therefore easy to implement and at low cost.

It is made clear that the above mentioned restrictions on size are not limitative to the invention. If other HDP parameters are used and/or a more expensive lithography step, and/or a nitride selective etch step for the 'clear-out', smaller active areas may come into focus for this clear out. Under these conditions, the region 8 may be chosen to be larger than described above. With respect to the uniformity of the CMP process, described after this, it is however highly recommended to leave areas 23 at the edges of large active areas.

Besides the clear-out step, no further patterning of the second CMP resistant layer 7 is performed in the method of the invention.

The CMP is done next. As seen in figure 3, only small volumes 22 and 23 remain above the surface level 10. The volumes 22 above small active areas have pointed edges at the top : without the layer 7, they would be removed much too quickly by CMP, due to a large local pad pressure on these pointed edges. Now, the layer 7 reduces the polishing speed on these places sufficiently to avoid this phenomenon. The volumes 23 at the edges of the active areas are partially covered by the layer 7, which will likewise produce the effect of slowing down the removal speed of these volumes by CMP. These volumes should be sufficiently small to avoid a significant difference in polishing speed between volumes 22 and 23. On the other hand, as already mentioned, these volumes 23 should have a minimum size in order to ensure the protection of the edges of the active areas 2. The height of the volumes 23 is in most cases higher than that of the volumes 22, due to the specifics of the HDP process (deposition/etch ratio), in conjunction with the size of the active areas. However, the size of all features 22 and 23 remaining after the clear-out step, are of the same order of magnitude.

According to the invention, all the features (22, 23) protruding above the surface level 10 are polished at a similar reduced polishing speed, due to their similar volume and the fact that they are all at least partially covered by the layer 7 : the resistance to CMP is essentially equal in every part.

Moreover, since there is no patterning of the layer 7 apart from the clear-out, this layer protects the field regions in their totality (for example region 24 in figure 3), and independently of their size. This is contrary to the dual nitride technique, wherein only the central parts of large field regions are protected by a CMP resistant layer. In the method of the invention therefore, the dishing effect is eliminated. Furthermore, differences in polish speed between different parts of the substrate are minimised, so that within one given polish time, all the oxide on the large active areas 2 is efficiently removed, without any of the nitride layer 4 on top of small active areas being eroded, and without any field oxide 6 in any of the field regions (trenches) being removed.

The polishing step is stopped when the layers 4 and 7 are reached. In the ideal case, the top surfaces of these layers are at exactly the same height, and polishing is stopped when reaching said height. Practically, a height difference of maximum 30nm can be allowed. This small difference can be eliminated in the last stages of the CMP process, leaving a completely even surface, as shown in figure 4. Figure 5 shows the wafer after removal of the CMP resistant materials.

Several options are proposed according to the present invention, concerning the materials used for the CMP resistant layers. According to one embodiment based on a semiconductor, e.g. a silicon wafer, both layers 4 and 7 may consist of silicon nitride. As a first alternative, two layers of silicon carbide (SiC) are used. One preferred embodiment uses nitride for the first CMP resistant layer 4 and SiC for the second layer 7.

According to another embodiment, the CMP resistant layers may be formed as follows (see figure 6a and 6b), for example in the case of the second CMP resistant layer 7. On top of the layer 7, a silicon-oxy-nitride layer (SiₓO_{y}N_{z}) layer 11 is deposited. It is to be noted that the atomic percentages (x,y,z) of silicon, oxygen and nitrogen in this layer 11 are variable within limits, as long as a detectable amount of every one of the components Si, O, N is present in the layer 11. In the state of the art, SiON is used primarily as an anti-reflective coating on the first CMP resistant layer 4. The present invention reveals however another useful aspect of a SiₓO_{y}N_{z} layer.

According to a preferred embodiment, the thickness of the layer 11 is 65nm, and its composition is as follows, expressed in atomic percentages: 52% Si, 5% N, 43% O, i.e. x=0.52; y=0.43; z=0.05.

After deposition of the SiₓO_{y}N_{z}, the wafer is subjected to a thermal anneal, preferably between 1050°C and 1100°C, during a period of time, preferably between 10 and 40 minutes. Such an anneal step of 27 minutes at 1075°C causes part of the 65nm thick SiₓO_{y}N_{z} layer to oxidise leaving a SiₓO_{y}N_{z} layer 12 of 45nm, plus on top of that a thin oxide (SiO₂) layer 13, approximately 8nm thick, see fig. 6b. At the interface between the layer 7 and the SiₓO_{y}N_{z} layer 12 however, a chemical reaction has taken place during the anneal step, and created at said interface, a thin layer 14 with an extremely high resistance to CMP.

This particular CMP resistant layer 14 is not known in the art. According to a preferred embodiment, the layer 14 is formed on top of a silicon nitride layer 7, by the steps described above. The CMP resistant layer 14 may however be obtained by the same process steps on any other layer besides a nitride layer. It may be obtained directly on the field dielectric 6 by said process steps.

The removal of the thin CMP resistant layer 14 is done by a dry etching technique. This may be a known dry etching technique normally used for the removal of nitride layers.

Independent of the type of CMP resistant materials used for both the layers 4 and 7, the difference in height between the field-protecting layers and the active area-protecting layers needs to be controlled and kept within given limits, as was already mentioned. As a general rule, the thickness of the second CMP resistant layer 7 is adapted to the thickness of the first layer 4 and of the trench filling oxide, so that the difference in height between the top of layers 4 and 7 does not exceed 30nm. In case of a SiₓO_{y}N_{z} layer treated by the steps described above, it is the difference in height between the top of CMP resistant layers 4 and 14 which is to be kept within these limits (preferably also between 0 and 30nm).

### Description of preferred embodiments of the invention

A first preferred embodiment of the invention relates to the method of the invention for performing STI-CMP on a silicon wafer, using a SiC layer as the second CMP resistant layer 7. What follows is the complete sequence of production steps to obtain the surface as depicted in figure 5, starting from a flat substrate. Only those steps that were described above form characteristic features of the invention. The numeric values of layer thicknesses and temperatures are non-restrictive to the patent's scope. The following sequence of steps is an example of the method, enabling a person skilled in the art, to perform the method. Any know process step may be performed after this sequence, in order to obtain semiconductor devices, which fall within the scope of the present invention.
1. providing a Silicon wafer
2. deposition of a thin thermal oxide layer, 15nm thick
3. deposition of 100nm of Si₃N₄, to produce the first CMP resistant layer 4,
4. depositing and patterning a resist layer on top of what will later become the active areas 2,
5. etching the trenches 5 adjacent to the active area regions. Total removed layer thickness is 515nm = 100nm Si₃N₄ + 15nm SiO₂ + 400nm Si.
6. resist strip
7. HF-dip for rounding the side walls of the trenches
8. Side wall oxide deposition with a thickness of 20nm
9. Deposition of trench filling oxide layer 6 by HDP process : thickness is 450nm
10. Depositing 50nm of SiC on top of HDP oxide layer, to produce second CMP resistant layer 7
11. Deposition and patterning of resist on the whole surface except above the large active areas (regions 8)
12. Performing a dry etch to remove 50nm of SiC and 250nm of HDP oxide on said large active areas, leaving 'clear-out' regions 8,
13. resist strip
14. Depositing 50nm of DXZ oxide
15. Performing CMP until reaching the SiC layer 7 on top of the field regions and the Si₃N₄ layers 4 on top of the active areas.
16. Dry etch to remove SiC layer 7 on field regions and Si₃N₄ layer 4 on active areas
17. resist strip

The second embodiment is related to performing STI-CMP, but using a SiₓO_{y}N_{z} layer with composition 52% Si, 5% N, 43% O, and thermal treatment to obtain the second CMP resistant layer 7. This sequence comprises the exact same steps 1 to 9 as the previous one. After that, the steps are :
10. deposition of 50nm of Si₃N₄ (layer 7) on top of the HDP oxide layer
11. deposition of 65nm of SiₓO_{y}N_{z} (layer 11) on top of the Si₃N₄ layer
12. thermal treatment at 1075°C to form a layer of 45nm SiₓO_{y}N_{z} and on top of that a layer of 8nm of silicon oxide, both layers being situated on top of the Si₃N₄ layer, and a CMP resistant layer 14 at the interface between Si₃N₄ and SiₓO_{y}N_{z}
13. deposition and patterning of resist on the whole surface except above the large active areas
14. Performing a dry etch to remove 50nm of SiₓO_{y}N_{z}, 50nm of Si₃N₄, and 250nm of HDP oxide on said large field regions, leaving 'clear-out' regions 8
15. resist strip
16. Depositing 50nm of DXZ oxide
17. Performing CMP until reaching the CMP resistant layer 14 on the interface between Si₃N₄ and SiₓO_{y}N_{z}, and the Si₃N₄ layer 4 on the active areas
18. Dry etch to remove CMP resistant layer 14, nitride layer 7 underneath said CMP resistant layer 14, and nitride layer 4 on top of active areas
19. resist strip

## Claims

1. A method for producing semiconductor devices from a semiconductor substrate (1), comprising the following steps :
- providing a substrate (1) having on its surface a number of elevated areas (2) separated by areas (5) which are at a lower level, each elevated area (2) having as its top surface a first layer (4) of a material which is resistant to Chemical Mechanical Polishing,
- Depositing a layer (6) of a dielectric on top of the whole of said substrate (1), at least filling up said lower level areas (5) between said elevated areas (5),
- Depositing a second layer (7) of a material which is resistant to CMP on top of the whole of said layer (6) of a dielectric,
- Removing parts (8) of said second CMP resistant layer (7) and of said layer (6) of a dielectric, said parts being situated above elevated areas (2) having a dimension larger than a predefined minimum,
- Performing a CMP step, said CMP being stopped at the location of said first and second CMP resistant layers (4,7).

2. A method according to claim 1, wherein at least one of said elevated areas (2) has a rectangular top surface and wherein said dimension is the width of said rectangular top surface.

3. A method according to claim 1 or 2, wherein the surface, parallel to the substrate, of said parts (8) that are removed, is not larger than the surface of said elevated areas (2) above which said parts (8) are situated.

4. A method according to claim 2, wherein said predefined minimum is 1.8µm.

5. A method according to any one of claims 1 to 4 wherein said first and/or said second CMP resistant layers (4,7) are silicon nitride layers.

6. A method according to any one of claims 1 to 4, wherein said first and/or said second CMP resistant layers (4,7) are silicon carbide layers.

7. A method according to any one of claims 1 to 4, wherein the forming of said first (4) and/or second layer (7) of CMP resistant material comprises the following steps :
- depositing a layer of SiₓO_{y}N_{z} (11),
- performing a thermal anneal, so that after said anneal a CMP resistant layer (14) is formed underneath said SiₓO_{y}N_{z} layer.

8. A method according to claim 7, further comprising the step of forming a Silicon nitride layer and wherein said SiₓO_{y}N_{z} layer is deposited on top of said Silicon nitride layer.

9. A method according to claim 7, further comprising the step of forming a Silicon carbide layer and wherein said SiₓO_{y}N_{z} layer is deposited on top of said Silicon carbide layer.

10. A method according to claim 7, wherein said SiₓO_{y}N_{z} layer is deposited on said layer (6) of dielectric material.

11. A method according to any one of claims 7 to 10, wherein said thermal anneal takes place at a temperature which is lying between 1050°C and 1100°C and during a period of time between 10 minutes and 40 minutes.

12. A method according to claim any one of claims 7 to 11, wherein said SiₓO_{y}N_{z} layer has a thickness, before the anneal step, of at least 60nm.

13. A method according to any one of the claims 1 to 12, wherein said dielectric layer (6) is formed by a high density plasma technique.

14. A method according to any one of the preceding claims, wherein said elevated areas (2) and said areas (5) at a lower level are created using the technique of Shallow Trench Isolation.

15. A method according to any one of the claims 1 to 13, wherein said elevated areas (2) consist of dummy gate stacks in a replacement gate technique.

16. A device obtained by the method according to any one of the claims 1 to 15.
